(19) Europäisches Patentamt
European Patent Office
Office européen des brevets

(11) **EP 3 429 319 A1**

(12) **EUROPEAN PATENT APPLICATION**
published in accordance with Art. 153(4) EPC

(43) Date of publication:
**16.01.2019 Bulletin 2019/03**

(51) Int Cl.:
**H05K 1/02** (2006.01)  **G06F 3/041** (2006.01)
**G06F 3/044** (2006.01)  **H05K 3/20** (2006.01)

(21) Application number: **17763281.7**

(22) Date of filing: **08.03.2017**

(86) International application number:
**PCT/JP2017/009122**

(87) International publication number:
**WO 2017/154941 (14.09.2017 Gazette 2017/37)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **08.03.2016 JP 2016044106**

(71) Applicant: **Fujikura Ltd.**
**Tokyo 135-8512 (JP)**

(72) Inventor: **OGURA, Shingo**
**Sakura-shi**
**Chiba 285-8550 (JP)**

(74) Representative: **Ter Meer Steinmeister & Partner**
**Patentanwälte mbB**
**Artur-Ladebeck-Strasse 51**
**33617 Bielefeld (DE)**

(54) **WIRING MEMBER, WIRING SUBSTRATE, AND TOUCH SENSOR**

(57) A wiring body 3 includes: a resin portion 4; and a conductor portion 5 (a conductor line 51) which is disposed on the resin portion 4 and is formed of a single conductive material, and the conductor line 51 includes: a main body portion 52 which includes a conductor portion contact surface 53 in contact with the resin portion 4, and a conductor portion top surface 54 on a side opposite to the conductor portion contact surface 53; and protruding portions 561 and 562 which are disposed on at least one end portion of the conductor portion top surface 54 and protrude towards a side separated from the resin portion 4 in the cross-sectional view.

FIG. 2

Printed by Jouve, 75001 PARIS (FR)

Description

TECHNICAL FIELD

The present invention relates to a wiring body, a wiring board, and a touch sensor.

For designated countries that are permitted to be incorporated by reference in the literature, the contents of Patent Application No. 2016-044106, filed with Japan Patent Office on March 8, 2016 is incorporated herein by reference and is regarded as a part of the description of this specification.

BACKGROUND ART

As electromagnetic shielding material, it is known that a conductive layer is formed on a primer layer having a mountain shape. In such an electromagnetic shielding material, a mountain shape portion is formed in the primer layer, and thus, adhesiveness between the primer layer and the conductive layer is improved (for example, refer to Patent Document 1).

In addition, as a conductive pattern containing conductive particles and a resin binder, it is known that a metal layer in which end corner portions of both side end edges protrudes on a top surface of the conductive pattern and a central portion is recessed is formed (for example, refer to Patent Document 2).

CITATION LIST

PATENT DOCUMENT

Patent Document 1: WO 2008/149969 A
Patent Document 2: JP 2012-169353 A

SUMMARY OF THE INVENTION

PROBLEM TO BE SOLVED BY THE INVENTION

In a case where a resin material is laminated on the electromagnetic shielding material described in Patent Document 1 so as to cover the conductive layer, a stress is concentrated on an interface between the conductive layer and the resin material, and peeling easily occurs between the conductive layer and the resin material.

In addition, concerning the conductive pattern described in Patent Document 2, peeling occurs between the conductive pattern and the metal layer, and there is a concern that the conductive pattern is destroyed.

An object of the present invention is to provide a wiring body, a wiring board and a touch sensor which are capable of suppressing peeling with respect to the laminated resin material and of suppressing destruction of a conductor portion.

MEANS FOR SOLVING PROBLEM

[1] A wiring body according to the present invention is a wiring body including: a resin portion; and a conductor portion which is disposed on the resin portion and is formed of a single conductive material, in which the conductor portion includes a main body portion which includes a contact surface in contact with the resin portion, and a top surface on a side opposite to the contact surface; and a protruding portion which is disposed on at least one end portion of the top surface and protrudes towards a side separated from the resin portion in the cross-sectional view.

[2] In the wiring body according to the present invention described above, the protruding portion may be disposed on both ends of the top surface in the cross-sectional view.

[3] In the wiring body according to the present invention described above, the protruding portion may be in a tapered shape in which the protruding portion is narrowed as being directed towards a side separated from the resin portion.

[4] In the wiring body according to the present invention described above, the conductor portion may include conductive particles and a binder resin, and at least a tip end of the protruding portion may be formed of the binder resin.

[5] In the wiring body according to the present invention described above, a following Expression (1) may be satisfied:

$$0.1 \ \mu m \le H_1 \le 1.0 \ \mu m \ \ldots(1)$$

where $H_1$ is a height of the protruding portion in the Expression (1).

[6] In the wiring body according to the present invention described above, a following Expression (2) may be satisfied:

$$0.1 \ \mu m \le W_1 \le 1.0 \ \mu m \ \ldots(2)$$

where $W_1$ is a width of the protruding portion in the Expression (2).

[7] In the wiring body according to the present invention described above, surface roughness of the contact surface may be relatively greater than surface roughness of the top surface.

[8] In the wiring body according to the present invention described above, the top surface may include a flat portion which is linear and is connected to the protruding portion in the cross-sectional view.

[9] In the wiring body according to the present invention described above, a width of the flat portion may be greater than or equal to half of a width of the top surface.

[10] In the wiring body according to the present invention described above, the main body portion may include a side surface interposed between the contact surface and the top surface in the cross-sectional view, and the side surface may be inclined to be close to the center of the conductor portion as being separated from the resin portion in the cross-sectional view.

[11] In the wiring body according to the present invention described above, the wiring body may further include a coating layer which is disposed to directly cover the conductor portion.

[12] A wiring board according to the present invention is a wiring board including: the wiring body described above; and a support body which supports the wiring body.

[13] A touch sensor according to the present invention is a touch sensor including: the wiring board described above.

EFFECT OF THE INVENTION

According to the present invention, in a case where the resin material is laminated on the conductor portion, the protruding portion enters the resin material, and thus, it is possible to suppress peeling between the wiring body and the resin material.

In addition, according to the present invention, there is no interface in the conductor portion by forming the conductor portion of the single conductive material, and thus, it is possible to suppress destruction of the conductor portion.

BRIEF DESCRIPTION OF DRAWINGS

Fig. 1 is a perspective view illustrating a wiring board in one embodiment of the present invention.
Fig. 2 is a cross-sectional view along line II-II of Fig. 1.
Fig. 3 is a cross-sectional view along line III-III of Fig. 1.
Fig. 4 is a cross-sectional view illustrating a conductor portion in one embodiment of the present invention.
Fig. 5(A) to Fig. 5(E) are cross-sectional views illustrating a manufacturing method of the wiring board in one embodiment of the present invention.
Fig. 6(A) to Fig. 6(C) are cross-sectional views illustrating a producing procedure of an intaglio in one embodiment of the present invention.
Fig. 7(A) to Fig. 7(E) are cross-sectional views illustrating a modification example of the manufacturing method of the wiring board in one embodiment of the present invention.

Fig. 8 is a diagram for illustrating an action of a wiring body in one embodiment of the present invention.
Fig. 9 is a plan view illustrating a touch sensor in one embodiment of the present invention.
Fig. 10 is an exploded perspective view illustrating the touch sensor in one embodiment of the present invention.
Fig. 11 is a cross-sectional view along line XI-XI of Fig. 9.
Fig. 12 is a cross-sectional view along line XII-XII of Fig. 9.

MODE(S) FOR CARRYING OUT THE INVENTION

Hereinafter, an embodiment of the present invention will be described on the basis of the drawings.

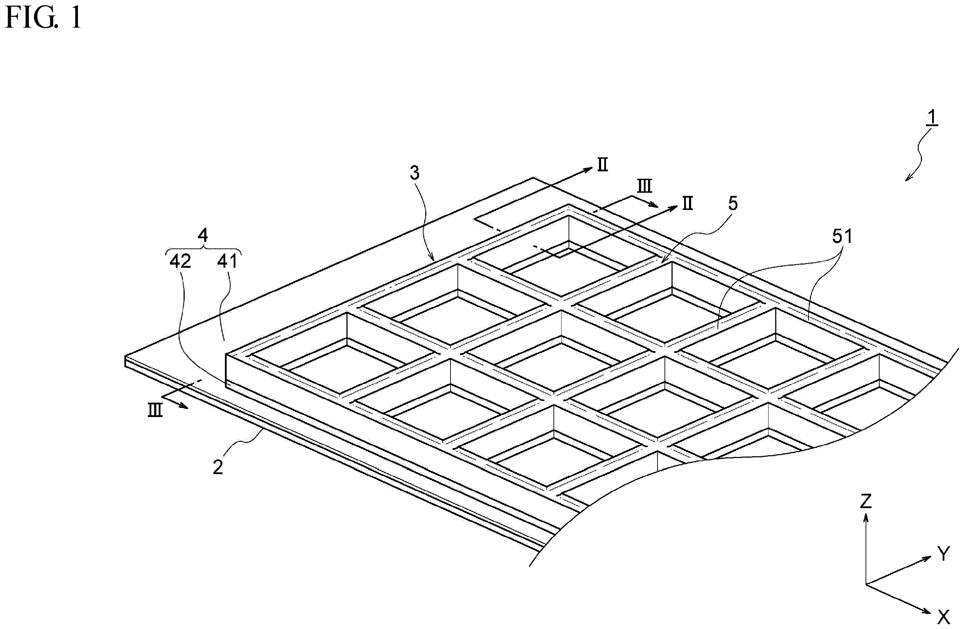

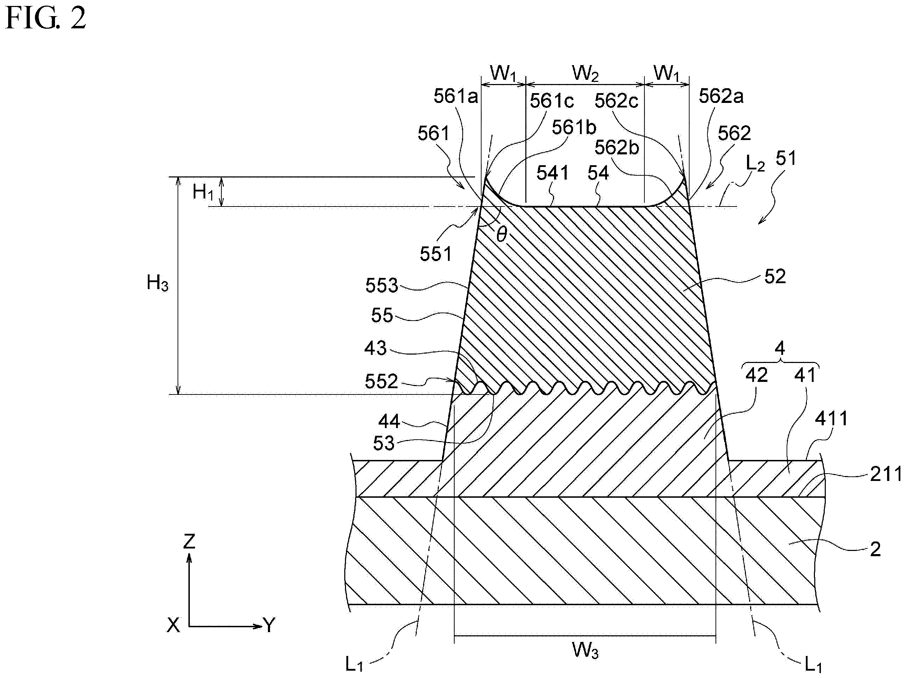

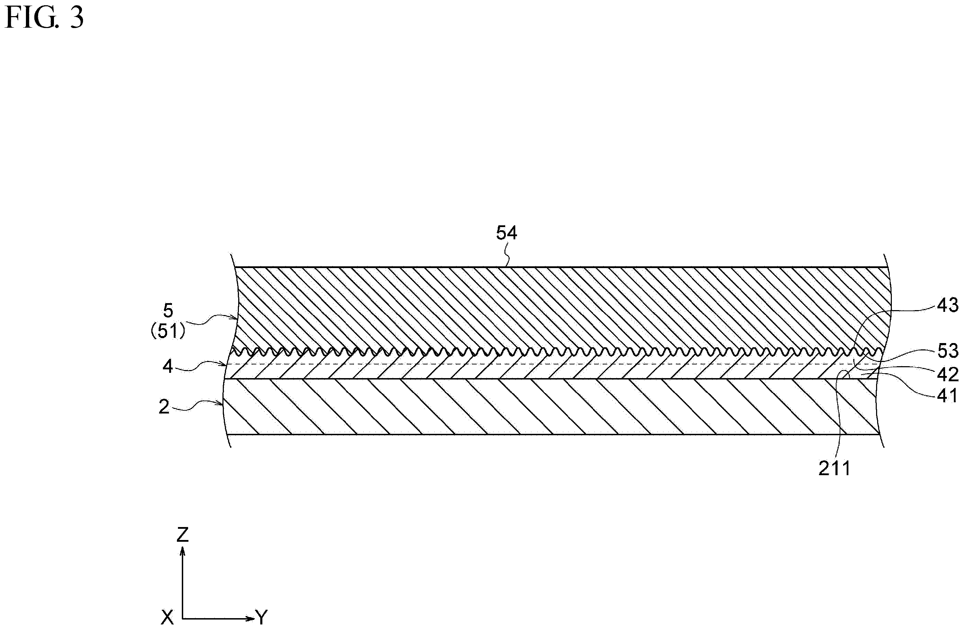

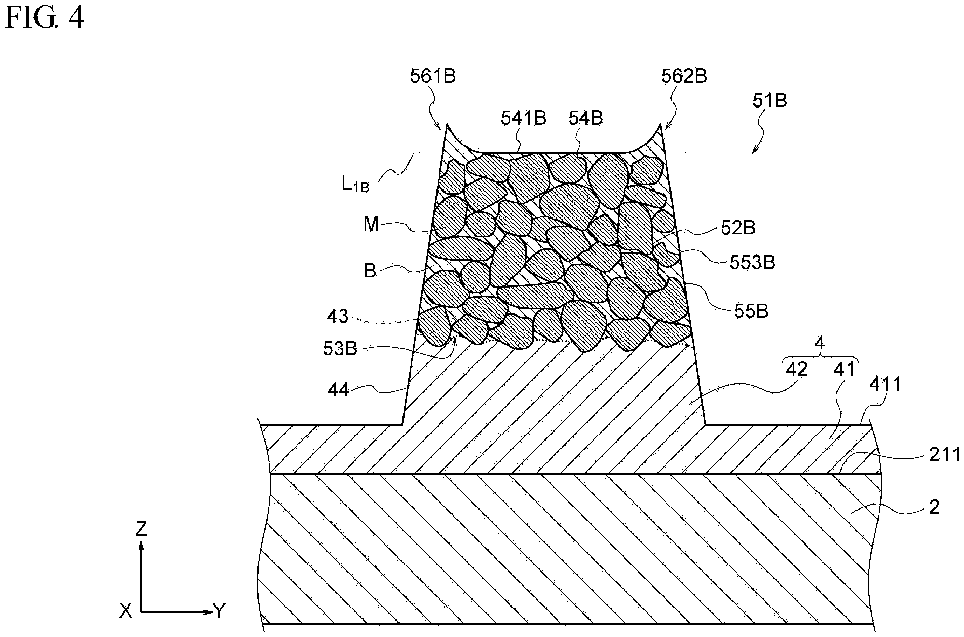

Fig. 1 is a perspective view illustrating a wiring board in one embodiment of the present invention, Fig. 2 is a cross-sectional view along line II-II of Fig. 1, Fig. 3 is a cross-sectional view along line III-III of Fig. 1, and Fig. 4 is a cross-sectional view illustrating a conductor portion in one embodiment of the present invention.
A wiring board 1 in this embodiment is used by being built in a touch sensor of a touch panel or the like. As illustrated in Fig. 1, the wiring board 1 includes a substrate 2 and a wiring body 3. The "wiring board 1" in this embodiment corresponds to an example of the "wiring board" in the present invention, and the "wiring body 3" in this embodiment corresponds to an example of the "wiring body" in the present invention.
The substrate 2 is a transparent substrate which is capable of transmitting a visible light ray and supports the wiring body 3. Polyethylene terephthalate (PET), polyethylene naphthalate (PEN), a polyimide resin (PI), a polyether imide resin (PEI), polycarbonate (PC), polyether ether ketone (PEEK), a liquid crystal polymer (LCP), a cycloolefin polymer (COP), a silicone resin (SI), an acrylic resin, a phenolic resin, an epoxy resin, a green sheet, glass and the like can be exemplified as a material of which such a substrate 2 is made. An easily adhesive layer or an optical adjusting layer may be formed on the substrate 2. The "substrate 2" in this embodiment corresponds to an example of the "support body" in the present invention.
The wiring body 3 includes a resin portion 4 and a conductor portion 5. The resin portion 4 is a layer for retaining the conductor portion 5 on the substrate 2, and for example, is made of an insulating material such as a UV curable resin, a thermosetting resin or a thermoplastic resin such as an epoxy resin, an acrylic resin, a polyester resin, a urethane resin, a vinyl resin, a silicone resin, a phenolic resin or a polyimide resin, or a ceramic green sheet.
As illustrated in Fig. 2, the resin portion 4 includes: a layer-like flat portion 41 which is disposed on a main surface 211 of the substrate 2; and a convex portion 42 which is integrally formed with the flat portion 41 on the flat portion 41. The flat portion 41 is disposed so as to cover the main surface 211 of the substrate 2 and has a substantially uniform thickness. It is preferable that a thickness of the flat portion 41, for example, is 5 $\mu$m to 100 $\mu$m. A main surface 411 of the flat portion 41 is a substantially flat surface and extends substantially in parallel with the main surface 211 of the substrate 2.

The convex portion 42 is disposed corresponding to the conductor portion 5 (specifically, a conductor line 51 (described below)) and supports the conductor portion 5. The convex portion 42 protrudes towards the conductor portion 5 side from the main surface 411 of the flat portion 41 in a width direction cross section of the conductor line 51. In the wiring body 3, the convex portion 42 is formed between the flat portion 41 and the conductor portion 5, and thus, it is possible to increase the thickness of the resin portion 4 at a portion supporting the conductor portion 5 and to improve rigidity of the resin portion 4. Accordingly, when the wiring body 3 is curved, the conductor portion 5 is hardly peeled from the resin portion 4. The height of the convex portion 42 is not particularly limited. For example, the height of the flat portion 41 and the height of the convex portion 42 may be equal to each other. The height of the flat portion 41 may be higher than the height of the convex portion 42, or on the contrary, the height of the flat portion 41 may be lower than the height of the convex portion 42. The "width direction of the conductor line 51" indicates a transverse direction of the conductor line 51 and is a direction orthogonal to an extending direction of the conductor line 51.

The convex portion 42 includes a resin portion contact surface 43 and a resin portion side surface 44 in the width direction cross section of the conductor line 51. The resin portion contact surface 43 is a surface in contact with the conductor portion 5. In this embodiment, a conductor portion contact surface 53 (described below) of the conductor portion 5 (the conductor line 51) is in an unevenness shape, and according to this, the resin portion contact surface 43 is in an unevenness shape which is complementary with respect to the unevenness shape of the conductor portion contact surface 53. As illustrated in Fig. 3, the resin portion contact surface 43 and the conductor portion contact surface 53 are in a complementary unevenness shape in an extending direction cross section of the conductor line 51. In Fig. 2 and Fig. 3, in order to describe the wiring body 3 of this embodiment to be easily understood, the unevenness shape of the resin portion contact surface 43 and the conductor portion contact surface 53 is exaggerated.

As illustrated in Fig. 2, the resin portion side surface 44 is connected to the resin portion contact surface 43 at one end portion, is connected to the main surface 411 at the other end portion, and is a surface which linearly extends between both ends. The resin portion side surface 44 is not covered with the conductor portion 5. In one convex portion 42, the resin portion side surfaces 44 and 44 are inclined to be close to each other as being separated from the flat portion 41. As a result thereof, the convex portion 42 is in a tapered shape in which the convex portion 42 is narrowed as being separated from the substrate 2 (the flat portion 41) in the width direction cross section of the conductor line 51.

In the plan view, a portion of the flat portion 41 which does not overlap with the convex portion 42 may be omitted. In this case, since light transmittance of the entire wiring body 3 is improved, visibility of a touch panel or the like on which the wiring body 3 is mounted is improved. The "resin portion 4" in this embodiment corresponds to an example of the "resin portion" in the present invention.

For example, the conductor portion 5 is used as an electrode of a touch sensor, and lead-out wiring which is electrically connected to the electrode. The conductor portion 5 of this embodiment is in a mesh shape (a reticular shape) configured of a plurality of linear conductor lines 51. The shape of each reticulation of the conductor portion 5 configured of the conductor line 51 is a substantially square. The shape of the reticulation is not particularly limited to the substantially square, but may be a triangle such as an equilateral triangle, an isosceles triangle, and a rectangular triangle, or may be a quadrangle such as a parallelogram and a trapezoid. Alternatively, the shape of the reticulation may be a n-sided polygon such as a hexagon, an octagon, a dodecagon and an icosagon, a circle, an ellipse, a star or the like.

Thus, a geometric pattern obtained by repeating various diagram units can be used as the shape of each reticulation of the conductor portion 5. The conductor line 51 of this embodiment is in a straight line shape, but may be in a curve shape, a horseshoe shape, a zigzag line shape or the like, as long as the conductor line 51 linearly extends. The width of the conductor line 51 may be changed along the extending direction of the conductor line 51.

A width $W_3$ of the conductor line 51 is preferably 50 nm to 1000 $\mu$m, is more preferably 500 nm to 150 $\mu$m, is even more preferably 1 $\mu$m to 10 $\mu$m, and is still more preferably 1 $\mu$m to 5 $\mu$m. A height $H_3$ of the conductor line 51 is preferably 50 nm to 3000 $\mu$m, is more preferably 500 nm to 450 $\mu$m, and is even more preferably 500 nm to 10 $\mu$m.

In this embodiment, it is preferable that a relationship between the width $W_3$ of the conductor line 51 and the height $H_3$ of the conductor line 51 satisfies Expression (3) described below, and it is more preferable that the relationship satisfies Expression (4) described below. The width $W_3$ of the conductor line 51 indicates the maximum width in the width direction cross section of the conductor line 51. The height $H_3$ of the conductor line 51 indicates the maximum height in the width direction cross section of the conductor line 51 and indicates the sum of a height of a main body portion 52 (described below) and heights of first and second protruding portions 561 and 562 (described below).

$$0.5 \leq W_3/H_3 \ldots (3)$$

$$0.5 \leq W_3/H_3 \leq 3 \ldots (4)$$

A planar shape of the conductor portion 5 is not limited to the mesh shape as described above. For example, the conductor portion may be a straight line which is configured of one conductor line. Alternatively, the conductor portion may be a curve line which is configured of one conductor line.

Such a conductor portion 5 is formed of a single conductive material. In this embodiment, the conductive material includes a binder resin and conductive particles (a conductive powder) which are dispersed in the binder resin. A metal material such as silver, copper, nickel, tin, bismuth, zinc, indium, and palladium, and a carbon-based material such as a graphite, carbon black (furnace black, acetylene black, and ketchen black), a carbon nanotube and a carbon nanofiber can be exemplified as the conductive particles. A metal salt which is a salt of the metal-based material described above may be used instead of the conductive particles.

The conductor portion 5 formed of the single conductive material indicates that there is no interface in the conductive material configuring the conductor portion 5. As long as the conductor portion 5 is formed of the single conductive material, an existence ratio of each composition contained in the conductive material (for example, the conductive particles and the binder resin) may not be uniform in the entire conductor portion 5. That is, a region in which the conductive particles contained in the conductive material densely exist and a region in which the conductive particles sparsely exist may be mixed in the entire conductor portion 5. A region in which the binder resin contained in the conductive material densely exists and a region in which the binder resin sparsely exists may be mixed in the entire conductor portion 5.

For example, conductive particles having a particle diameter $\phi$ of greater than or equal to 0.5 $\mu$m and less than or equal to 2 $\mu$m ($0.5 \leq \phi \leq 2$) can be used as the conductive particles contained in the conductive material configuring the conductor portion 5, according to the width of the conductor line 51 to be formed. It is preferable to use conductive particles having an average particle diameter $\phi$ of less than or equal to half of the width of the conductor line 51 to be formed, in terms of stabilizing an electrical resistance value of the conductor portion 5. It is preferable to use particles having a specific surface area of greater than or equal to 20 m²/g, which is measured by a BET method, as the conductive particles.

In a case where the conductor portion 5 requires a comparatively small electrical resistance value which is less than or equal to a certain value, it is preferable that a metal material is used as the conductive particles. On the other hand, in a case where the conductor portion 5 allows a comparatively large electrical resistance value which is greater than or equal to a certain value, it is possible to use a carbon-based material as the conductive particles. It is preferable that the carbon-based material is used as the conductive particles, in terms of improving a haze or total light reflectance of a mesh film.

In this embodiment, since the conductor portion 5 is in a reticular shape, light transmittance is given to the conductor portion 5. For this reason, even in a case where the conductor portion 5 is used in a touch panel, a metal material such as silver, copper, and nickel and a conductive material such as the carbon-based material described above which have excellent conductivity but is opaque (an opaque metal material and an opaque carbon-based material) can be used as a material configuring the conductor portion 5.

An acrylic resin, a polyester resin, an epoxy resin, a vinyl resin, a urethane resin, a phenolic resin, a polyimide resin, a silicone resin, a fluorine resin and the like can be exemplified as the binder resin.

Such a conductor portion 5 is formed by being coated with a conductive paste and by curing the conductive paste. A conductive paste which is made by mixing conductive particles, a binder resin, water or a solvent, and various additives, can be exemplified as a specific example of the conductive paste. $\alpha$-Terpineol, butyl carbitol acetate, butyl carbitol, 1-decanol, butyl cellosolve, diethylene glycol monoethyl ether acetate, tetradecane and the like can be exemplified as the solvent contained in the conductive paste. The binder resin may be omitted from the material configuring the conductor portion 5.

The conductor line 51 of this embodiment includes: the main body portion 52; and the first and second protruding portions 561 and 562. The main body portion 52 is a portion of the conductor line 51 which is directly disposed on the convex portion 42. The main body portion 52 includes: the conductor portion contact surface 53; a conductor portion top surface 54; and two conductor portion side surfaces 55 and 55 in the width direction cross section of the conductor line 51.

The "conductor portion 5" and the "conductor line 51" in this embodiment corresponds to an example of the "conductor portion" in the present invention, the "main body portion 52" in this embodiment corresponds to an example of the "main body portion" in the present invention, the "first and second protruding portions 561 and 562" in this embodiment corresponds to an example of the "protruding portion" in the present invention, the "conductor portion contact surface 53" in this embodiment corresponds to an example of the "contact surface" in the present invention, the "conductor portion top surface 54" in this embodiment corresponds to an example of the "top surface" in the present invention, and the "conductor portion side surface 55" in this embodiment corresponds to an example of the "side surface" in the present invention.

The conductor portion contact surface 53 has in an unevenness shape and is in close contact with the resin portion contact surface 43 of the convex portion 42. The unevenness shape of the conductor portion contact surface 53 is formed on the basis of surface roughness of the conductor portion contact surface 53. The surface roughness of the conductor portion contact surface 53 will be described below in detail. The conductor portion top surface 54 is positioned on a side opposite to the conductor portion contact surface 53. The conductor portion top surface 54 of this embodiment extends in a direction which is substantially parallel to the main surface 211 of the substrate 2 (the main surface 411 of the flat portion 41 of the resin portion 4).

The conductor portion top surface 54 includes a top surface flat portion 541 which is linear in the width direction cross section of the conductor line 51. The width of the top surface flat portion 541 is wider than or equal to half of the width of the conductor portion top surface 54 in the width direction cross section of the conductor line 51. Since the width of the top surface flat portion 541 is wider than or equal to half of the width of the conductor portion top surface 54, it is possible to suppress diffused reflection of light incident from the outside. A flatness of the top surface flat portion 541 is less than or equal to 0.5 $\mu$m. A width $W_2$ of the top surface flat portion 541 is not particularly limited, but for example, is preferably 0.5 $\mu$m to 10 $\mu$m.

The flatness can be defined by a JIS method (JIS B0621 (1984)). As a measurement method, the flatness of the top surface flat portion 541 is obtained by a non-contact type measurement method using laser light. Specifically, a measurement target (for example, the conductor portion top surface 54 or the conductor portion side surface 55) is irradiated with strip-like laser light, and an image is formed on an imaging device (for example, a two-dimensional CMOS) by reflection light thereof, and thus, the flatness is measured. As a calculation method of the flatness, a method in which a plane passing through three points maximally separated from each other is set in a target surface, and a maximum value of a deviation thereof is calculated as the flatness (a maximum deflection flatness) is used. The measurement method and the calculation method of the flatness is not particularly limited to the above description. For example, the measurement method of the flatness may be a contact type measurement method using a dial gauge or the like. As the calculation method of the flatness, a method in which a value of a gap formed at the time of interposing a target surface between parallel planes is calculated as the flatness (a maximum inclination type flatness) may be used. The "top surface flat portion 541" in this embodiment corresponds to an example of the "flat portion" in the present invention.

The conductor portion side surface 55 is interposed between the conductor portion contact surface 53 and the conductor portion top surface 54. The conductor portion side surface 55 of this embodiment is connected to the conductor portion contact surface 53 at one end portion 551, is connected to the conductor portion top surface 54 at the other end portion 552, and is a linear surface which exists along a virtual straight line $L_1$ passing through both ends 551 and 552. The conductor portion side surface 55 of the conductor portion 5 and the resin portion side surface 44 of the resin portion 4 are continuously connected to each other. Two conductor portion side surfaces 55 and 55 of one conductor line 51 are inclined to be close to the center of the sectional shape of the conductor line 51 as being separated from the resin portion 4. Two conductor portion side surfaces 55 and 55 of one conductor line 51 are inclined at substantially the same inclination angle. As a result thereof, the conductor line 51 of this embodiment is in a tapered shape in which the conductor line 51 is narrowed as being separated from the resin portion 4 in the width direction cross section of the conductor line 51. Two conductor portion side surfaces 55 and 55 of one conductor line 51 may be inclined at inclination angles different from each other.

In this embodiment, an angle θ between the conductor portion top surface 54 and the conductor portion side surface 55 is preferably 90° to 170° (90° ≤ θ ≤ 170°), and is more preferably 90° to 120° (90° ≤ θ ≤ 120°), in terms of suppressing diffused reflection of light on the conductor portion side surface 55. The angle θ between the conductor portion top surface 54 and the conductor portion side surface 55 indicates an angle between a virtual straight line $L_2$ extending along the conductor portion top surface 54 (in this embodiment, the top surface flat portion 541) and the virtual straight line $L_1$ passing through both ends 551 and 552 of the conductor portion side surface 55 in the width direction cross section of the conductor line 51.

Such a conductor portion side surface includes a side surface flat portion 553 in the width direction cross section of the conductor line 51. The side surface flat portion 553 is a linear portion which exists on the conductor portion side surface 55 in the width direction cross section of the conductor line 51. In this embodiment, the substantially entire conductor portion side surface 55 is formed of the side surface flat portion 553. The flatness of the side surface flat portion 553 is less than or equal to 0.5 $\mu$m, as with the top surface flat portion 541. In this embodiment, the virtual straight line $L_1$ extends along the side surface flat portion 553.

The shape of the conductor portion side surface 55 is not particularly limited to the above description. For example, the conductor portion side surface 55 may be in an arc shape in which the conductor portion side surface 55 protrudes towards the outside in the width direction cross section of the conductor line 51. In this case, the conductor portion side surface 55 exists on the outside of the virtual straight line $L_1$. That is, as the shape of the conductor portion side surface 55, a shape in which a part of the conductor portion side surface 55 does not exist on the inside of the virtual straight line $L_1$ in the width direction cross section of the conductor line 51 is preferable. For example, in a case where an outer shape of the conductor line is a shape in which the conductor line is gradationally widened as being close to the resin portion in a width direction cross section of the conductor line and a side surface of the conductor line is in an arc shape in which the side surface is concave towards the inside (that is, a shape in which the skirt of the conductor line is widened), there is a concern that light incident on the wiring body is easily diffused and reflected.

In this embodiment, it is preferable that the surface roughness of the conductor portion contact surface 53 of the conductor line 51 is relatively greater than the surface roughness of the conductor portion top surface 54 of the conductor line 51, in terms of rigidly fixing the conductor line 51 (the conductor portion 5) to the resin portion 4. In this embodiment, the conductor portion top surface 54 includes the top surface flat portion 541, and thus, a relative relationship of the surface roughness in the conductor line 51 (a relationship in which the surface roughness of the conductor portion contact surface 53 is relatively rougher than the surface roughness of the conductor portion top surface 54) is established. Specifically, it is preferable that surface roughness Ra of the conductor portion contact surface 53 of the conductor line 51 is approximately 0.1 $\mu$m to 3 $\mu$m, whereas the surface roughness Ra of the conductor portion top surface 54 is 0.001 $\mu$m to 1.0 $\mu$m. Furthermore, it is more preferable that the surface roughness Ra of the conductor portion contact surface 53 of the conductor line 51 is 0.1 $\mu$m to 0.5 $\mu$m, and it is more preferable that the surface roughness Ra of the conductor portion top surface 54 is 0.001 $\mu$m to 0.3 $\mu$m. A ratio of the surface roughness of the conductor portion top surface 54 to the surface roughness of the conductor portion contact surface 53 (the surface roughness of the conductor portion top surface 54 with respect to the surface roughness of the conductor portion contact surface 53) is preferably greater than or equal to 0.01 and less than 1, and is more preferably greater than or equal to 0.1 and less than 1. It is preferable that the surface roughness of the conductor portion top surface 54 is less than or equal to 1/5 of the width $W_3$ of the conductor line 51 (the maximum width). Such surface roughness can be measured by a JIS method (JIS B0601 (revised on March 21, 2013)). The surface roughness of the conductor portion contact surface 53 and the conductor portion top surface 54 may be measured along the width direction of the conductor line 51 (refer to Fig. 2), or may be measured along the extending direction of the conductor line 51 (refer to Fig. 3).

Incidentally, as described in the JIS method (JIS B0601 (revised on March 21, 2013)), the "surface roughness Ra" indicates "arithmetic average roughness Ra". The "arithmetic average roughness Ra" indicates a roughness parameter which is obtained by blocking a long wavelength component (a waviness component) from a sectional curve. The waviness component is separated from the sectional curve on the basis of a measurement condition necessary for obtaining a feature (for example, a dimension or the like of the target).

In this embodiment, since the conductor portion side surface 55 includes the side surface flat portion 553, the surface roughness of the conductor portion contact surface 53 is relatively greater than the surface roughness of the conductor portion side surface 55 including the side surface flat portion 553, as with the conductor portion top surface 54. As the surface roughness of the conductor portion side surface 55, it is preferable that the surface roughness Ra of the conductor portion side surface 55 is 0.001 $\mu$m to 1.0 $\mu$m, and it is more preferable that the surface roughness Ra of the conductor portion side surface 55 is 0.001 $\mu$m to 0.3 $\mu$m, with respect to the surface roughness Ra of the conductor portion contact surface 53. The surface roughness of the conductor portion side surface 55 may be measured along the width direction of the conductor line 51 (refer to Fig. 2), or may be measured along the extending direction of the conductor line 51 (refer to Fig. 3).

In the wiring body 3 of this embodiment, a relative relationship in the surface roughness between the conductor portion contact surface 53 and the other surface excluding the conductor portion contact surface 53 (the conductor portion top surface 54 and the conductor portion side surface 55) has the relationship described above, and thus, a diffused reflection rate of the wiring body 3 on the other surface side excluding the conductor portion contact surface 53 (that is, a surface side including the conductor portion top surface 54 and the conductor portion side surface 55) is relatively smaller than a diffused reflection rate of the wiring body 3 on the conductor portion contact surface 53 side. As a relative relationship in the diffused reflection rate between the front and rear of the wiring body 3, a ratio of the diffused reflection rate of the wiring body 3 on the other surface side excluding the conductor portion contact surface 53 to the diffused reflection rate of the wiring body 3 on the conductor portion contact surface 53 side (the diffused reflection rate of the wiring body 3 on the other surface side excluding the conductor portion contact surface 53 with respect to the diffused reflection rate of the wiring body 3 on the conductor portion contact surface 53 side) is preferably greater than or equal to 0.1 and less than 1, and is more preferably greater than or equal to 0.3 and less than 1.

As illustrated in Fig. 2, the first and second protruding portions 561 and 562 are formed on each of both ends of the conductor portion top surface 54 of this embodiment. The first and second protruding portions 561 and 562 protrude towards a side separated from the resin portion 4 and the main body portion 52. In this embodiment, the first and second protruding portions 561 and 562 are continuously formed along the circumference of the conductor portion top surface 54 of the conductor line 51 (refer to Fig. 1). The top surface flat portion 541 exists between the first and second protruding portions 561 and 562 in the width direction cross section of the conductor line 51 so as to be connected to the first and second protruding portions 561 and 562.

Shapes of the first and second protruding portions 561 and 562 will be described in detail. In this embodiment, since basic shapes of the first and second protruding portions 561 and 562 are the same, the first protruding portion 561 will be described in the following description, the repeated description concerning the second protruding portion 562 will be omitted, and the description in the first protruding portion 561 will be quoted.

The first protruding portion 561 of this embodiment is in a tapered shape in which the first protruding portion 561 is narrowed as being separated from the resin portion 4. In a case where the tip end 561c of the first protruding portion 561 is used as a reference, the first protruding portion 561 includes an outer side surface 561a which is positioned on the outside of the conductor line 51 from a tip end 561c and an inner side surface 561b which is positioned on the inside of the conductor line 51 from the tip end 561c in the width direction cross section of the conductor line 51. The outer side surface 561a is a linear surface which is inclined to be close to the center of the conductor line 51 as being separated from the main body portion 52. The outer side surface 561a and the conductor portion side surface 55 are continuously connected to each other. The inner side surface 561b is a surface in which the inner side surface 561b is concave in the shape of an arc towards the inside of the first protruding portion 561. The inner side surface 561b and the top surface flat portion 541 are connected to each other. The outer side surface 561a and the inner side surface 561b are close to each other as being separated from the main body portion 52. A portion in which the outer side surface 561a and the inner side surface 561b are in contact with each other forms the tip end 561c of the first protruding portion 561. The shape of the tip end 561c may be a rounded arc shape, or may be a sharp shape.

It is preferable that a height $H_1$ of the first protruding portion 561 is set within a range of Expression (5) described below. The height $H_1$ of the first protruding portion 561 is a distance along a Z direction from the virtual straight line $L_2$ to the tip end 561c in the width direction cross section of the conductor line 51.

$$0.1 \ \mu m \le H_1 \le 1.0 \ \mu m \ \dots (5)$$

It is preferable that a width $W_1$ of the first protruding portion 561 is set within a range of Expression (6) described below. The width $W_1$ of the first protruding portion 561 is a distance between the outer side surface 561a and the inner side surface 561b on a virtual straight line $L_2$ in the width direction cross section of the conductor line 51.

$$0.1 \ \mu m \le W_1 \le 1.0 \ \mu m \ \dots (6)$$

The width $W_1$ of the first protruding portion 561 is preferably less than or equal to 1/3 ($W_1 \le 1/3 \times W_3$), and is more preferably less than or equal to 1/5 ($W_1 \le 1/5 \times W_3$), with respect to the width $W_3$ of the conductor portion top surface 54.

The width of the first protruding portion 561 and the width of the second protruding portion 562 may be substantially the same, or may be different from each other. The height of the first protruding portion 561 and the height of the second protruding portion 562 may be substantially the same, or may be different from each other.

The each shape of the first and second protruding portions 561 and 562 is not limited to a tapered shape in which the first and second protruding portions 561 and 562 are narrowed as being separated from the resin portion 4. For example, although it is not particularly illustrated, the protruding portion may be formed so that the width of the protruding portion is substantially constant along the Z direction.

It is preferable that at least a tip end of the protruding portion is made of a binder resin, in terms of suppressing peeling from the resin material laminated on the conductor portion. This will be described by using a conductor line 51B illustrated in Fig. 4. In the conductor line 51B made of conductive particles M and a binder resin B, first and second protruding portions 561B and 562B are formed on both ends of a conductor portion top surface 54B of a main body portion 52B. In such an aspect, an interface between the first and second protruding portions 561B and 562B and the main body portion 52B is substantially coincident with a virtual straight line $L_{1B}$ which extends along a top surface flat portion 541B. The first and second protruding portions 561B and 562B are made of the binder resin B only and do not contain the conductive particles M. Here, a stress is easily concentrated on the tip end of the first and second protruding portions 561B and 562B. For this reason, in this embodiment, the tip end of the first and second protruding portions 561B and 562B is made of the binder resin B, and thus, an adhering force between the first and second protruding portions 561B and 562B and a resin material (not illustrated) laminated on the conductor line 51B is improved, and peeling between the first and second protruding portions 561B and 562B and the resin material is suppressed.

The configuration of the protruding portion is not particularly limited to the above description. For example, the first and second protruding portions 561 and 562 may be made of the conductive particles M and the binder resin B. In this case, for example, the conductive particles M may exist in the vicinity of the interface between the first and second protruding portions 561 and 562 and the main body portion 52, and the tip end of the first and second protruding portions 561 and 562 may be made of the binder resin B.

In a conductor portion contact surface 53B of the conductor line 51B illustrated in Fig. 4, a part of the conductive particles M protrude (are exposed) from the binder resin B. Accordingly, the conductor portion contact surface 53B is in an unevenness shape. On the other hand, in a conductor portion top surface 54B and a conductor portion side surface 55B of the conductor line 51B, the binder resin B enters between the conductive particles M. A slightly exposed portion of the conductive particles M are scattered on the conductor portion top surface 54B and the conductor portion side surface 55B, but the conductive particles M are approximately covered with the binder resin B. Accordingly, the conductor portion top surface 54B includes the top surface flat portion 541B, and the conductor portion side surface 55B includes a side surface flat portion 553B. As a relative relationship in the surface roughness between the conductor portion contact surface 53B and the conductor portion top surface 54B of the conductor line 51B, the surface roughness of the conductor portion contact surface 53B is relatively greater than the surface roughness of the conductor portion top surface 54B. The surface roughness of the conductor portion contact surface 53B is relatively greater than the surface roughness of the conductor portion side surface 55B. Since the conductive particles M are covered with the binder resin B in the conductor portion side surface 55B, electrical insulating properties between the adjacent conductor lines 51B are improved, and the occurrence of migration is suppressed.

In the embodiment described above, the protruding portion is formed on each of both ends of the top surface in the width direction cross section of the conductor portion, but is not particularly limited thereto as long as the protruding portion is formed on at least one end portion of the top surface. For example, although it is not particularly illustrated, the first protruding portion 561 may be formed only on one end portion of the conductor portion top surface 54 in the width direction cross section of the conductor line 51.

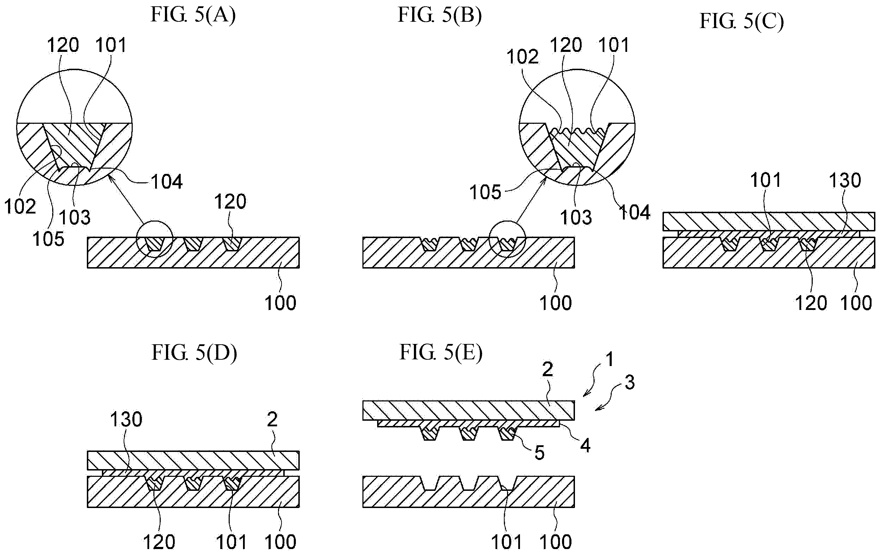

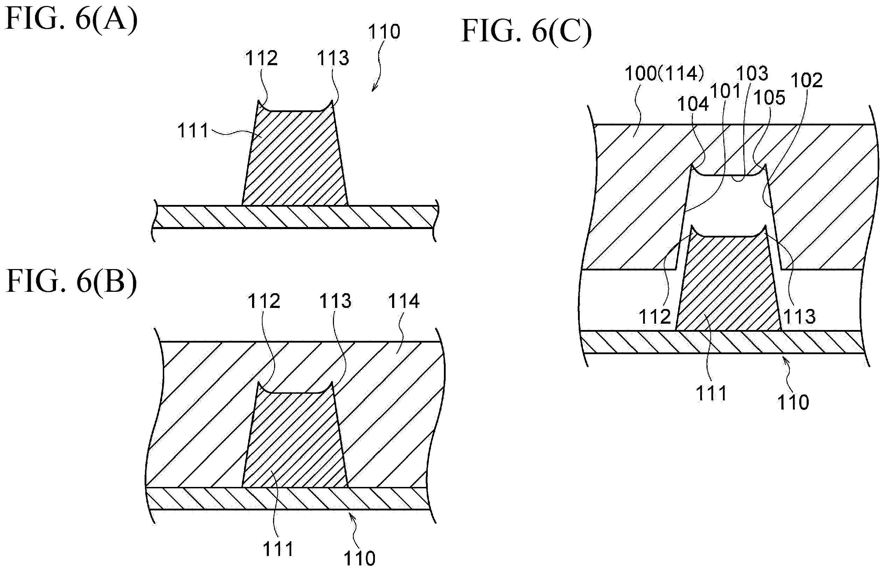

Next, a manufacturing method of the wiring board 1 in this embodiment will be described. Fig. 5(A) to Fig. 5(E) are cross-sectional views illustrating a manufacturing method of the wiring board in one embodiment of the present invention, and Fig. 6(A) to Fig. 6(C) are cross-sectional views illustrating a producing procedure of an intaglio in one embodiment of the present invention.

First, as illustrated in Fig. 5(A), an intaglio 100 on which a concave portion 101 having a shape corresponding to the conductor portion 5 is formed is prepared. Nickel, silicon, Glasses such as silicon dioxide, ceramics, organic silicas, glassy carbon, a thermoplastic resin, a photocurable resin and the like can be exemplified as a material of which the intaglio 100 is made.

The width of the concave portion 101 is preferably 50 nm to 1000 μm, is more preferably 500 nm to 150 μm, is even more preferably 1 μm to 10 μm, is still more preferably 1 μm to 5 μm. The height of the concave portion 101 is preferably 50 nm to 3000 μm, is more preferably 500 nm to 450 μm, and is even more preferably 500 nm to 10 μm.

An inner wall 102 of the concave portion 101 in this embodiment is a flat surface, and the inner wall 102 is inclined to be narrowed as being close to a bottom surface 103 of the concave portion 101 (refer to a lead-out diagram of Fig. 5(A)). Recessed portions 104 and 105 which are recessed towards a side separated from an opening side of the concave portion 101 are formed on each of both ends of the bottom surface 103. It is preferable that a release layer made of a black lead-based material, a silicone-based material, a fluorine-based material, a ceramic-based material, an aluminum-based material or the like is formed on a front surface of the intaglio 100 including the concave portion 101 in order to improve releasability.

The intaglio 100 of this embodiment can be produced by the following procedure. First, as illustrated in Fig. 6(A), a matrix 110 including a convex portion 111 corresponding to the concave portion 101 of the intaglio 100 is produced. The convex portion 111 includes protruding portions 112 and 113 corresponding to the recessed portions 104 and 105 of the concave portion 101. Such the matrix 110, for example, can be formed by using a method described in JP 2011-71542 A.

Then, as illustrated in Fig. 6(B), a metal layer 114 is deposited on the matrix 110 by electroforming (electroplating). Then, as illustrated in Fig. 6(C), the metal layer 114 is separated from the matrix 110, and thus, the intaglio 100 including the concave portion 101 is obtained. A producing procedure of the intaglio 100 is not particularly limited to the above description.

Returning to Fig. 5(A), the concave portion 101 of the intaglio 100 described above is filled with a conductive material 120. The conductive paste as described above is used as such a conductive material 120. A material to which conductivity is given by heating may be used. In this process, the conductive material 120 filling the concave portion 101 of the intaglio 100 is a single conductive material. For example, a dispense method, an ink jet method, and a screen printing method can be exemplified as a method of filling the concave portion 101 of the intaglio 100 with the conductive material 120. Alternatively, a method of wiping, scraping, sucking, sticking, rinsing, or blowing the conductive material which is applied to a portion other than the concave portion after performing coating by a slit coating method, a bar coating method, a blade coating method, a dip coating method, a spray coating method or a spin coating method can be exemplified. The filling method can be suitably used according to the composition of the conductive material, the shape of the intaglio or the like.

Next, as illustrated in Fig. 5(B), the conductive material 120 filling the concave portion 101 of the intaglio 100 is heated, and thus, the conductor line 51 configuring the conductor portion 5 is formed. A heating condition of the conductive material 120 can be suitably set according to the composition of the conductive material 120 or the like.

The volume of conductive material 120 shrinks with a heating treatment. At this time, an outer surface of the conductive material 120 excluding an upper surface 47 is formed in a shape including a flat surface along the inner wall 102 and the bottom surface 103 of the concave portion 101. In this case, the first and second protruding portions 561 and 562 are formed of the conductive material 120 filling the recessed portions 104 and 105 formed on the bottom surface 103. A relationship between the particle diameter $\phi$ of the conductive particles M and the width of the recessed portions 104 and 105 is suitably adjusted, and thus, it is possible to prevent the conductive particles M from entering the tip end of the first and second protruding portions 561 and 562 of the conductor line 51 to be formed. On the other hand, the upper surface of the conductive material 120 filling the concave portion 101 is heated in a state of being in contact with the external atmosphere. For this reason, an unevenness shape based on the shape of the conductive particles included in the conductive material 120 is formed on an upper surface of the conductor line 51. Since the conductive material 120 is heated and cured in this process, ,wet-spreading does not occur after the conductive material 120 is taken off from the concave portion 101 of the intaglio 100 in the subsequent process. A treatment method of the conductive material is not limited to heating. The conductive material may be irradiated with an energy ray such as an infrared ray, an ultraviolet ray or laser light, or the conductive material may only be dried. Two or more types of treatment methods may be combined.

Subsequently, as illustrated in Fig. 5(C), a resin material 130 for forming the resin portion 4 is applied onto the intaglio 100. The material described above configuring the resin portion 4, is used as the resin material 130. A screen printing method, a spray coating method, a bar coating method, a dipping method, an ink jet method and the like can be exemplified as a method of applying the resin material 130 onto the intaglio 100. According to such coating, the resin material 130 enters the concave portion 101 having the unevenness shape of the conductor line 51.

Subsequently, as illustrated in Fig. 5(D), the substrate 2 is disposed on the resin material 130 applied onto the intaglio 100. It is preferable that the substrate 2 is disposed on the resin material 130 under vacuum in order to prevent air bubbles from entering between the resin material 130 and the substrate 2. The material described above can be exemplified as a material of the substrate. An easily adhesive layer or an optical adjusting layer may be formed on the substrate. Next, the resin material 130 is solidified. Irradiation of an energy ray such as ultraviolet ray laser light or infrared ray laser light, heating, heating and cooling, drying and the like can be exemplified as a method of solidifying an adhesive material. Accordingly, the resin portion 4 is formed, and the substrate 2 and the conductor line 51 adhere to each other through the resin portion 4 and are fixed to each other.

In this embodiment, the substrate 2 is laminated after the resin material 130 is applied onto the intaglio 100, but the present invention is not particularly limited thereto. For example, the substrate 2 having the main surface (a surface facing the intaglio 100) on which the resin material 130 is applied in advance may be disposed on the intaglio 100, and thus, the substrate 2 may be laminated on the intaglio 100 through the resin material 130.

Next, the substrate 2, the resin portion 4 and the conductor portion 5 are released, and thus, it is possible to obtain the wiring board 1 (the wiring body 3) (refer to Fig. 5(E)).

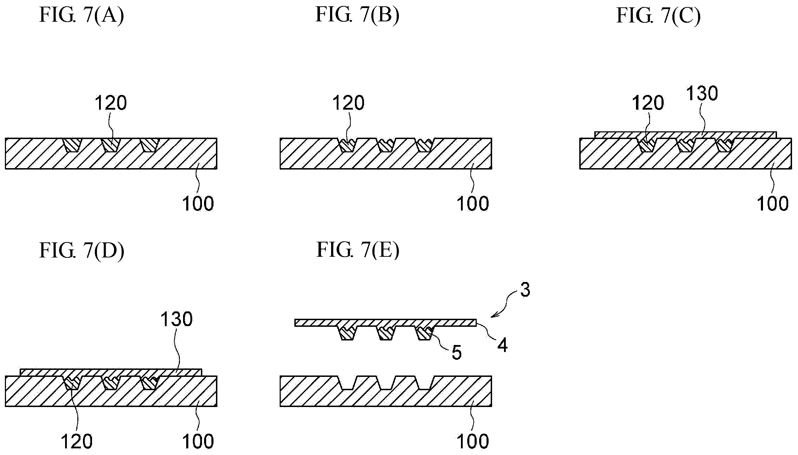

A manufacturing method of the wiring board 1 is not particularly limited to the above description. For example, a wiring body 3B may be manufactured according to a manufacturing method as illustrated in Fig. 7(A) to Fig. 7(E). Specifically, the conductive material 120 fills the intaglio 100 and is heated (Fig. 7(A) and Fig. 7(B)), a resin material 130B is applied onto the intaglio 100 (Fig. 7(C)), and the resin material 130B is solidified (Fig. 7(D)). Then, the solidified resin material 130B and the conductive material 120 (the conductor line 51) after being heated are separated from the intaglio 100 without using the substrate, and thus, it is possible to manufacture the wiring body 3.

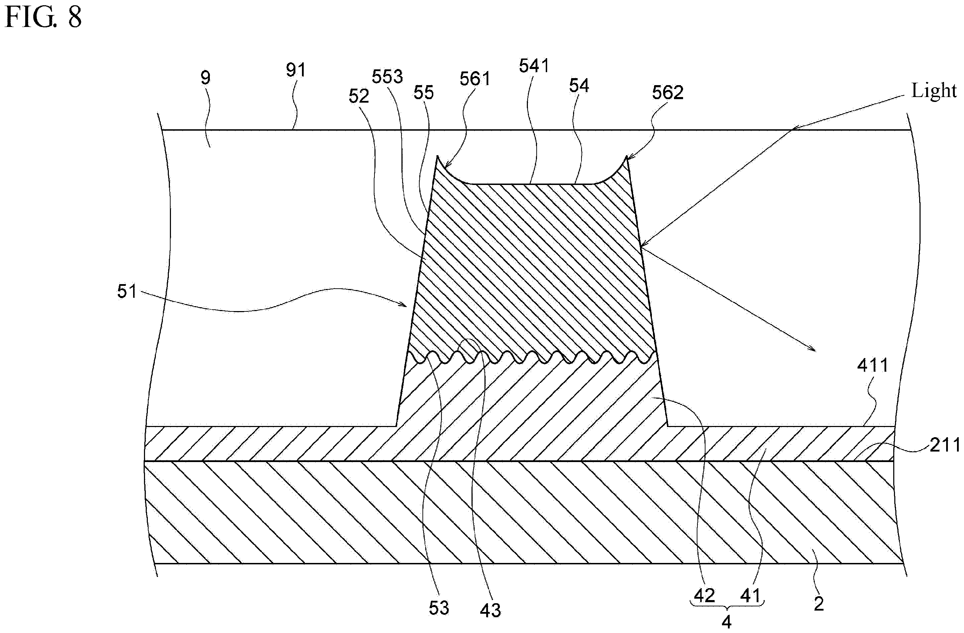

The wiring body 3 and the wiring board 1 of this embodiment have the following action and effect. Fig. 8 is a diagram for illustrating the action of the wiring body in one embodiment of the present invention.

A reference numeral of 9 illustrated in Fig. 8 is a coating layer covering the wiring body 3. The coating layer 9 has a function as a protective layer which protects the conductor portion 5 from the outside. In the wiring board 1, the coating layer 9 is disposed on the wiring body 3 to directly cover the conductor portion 5, and thus, scattering of light on a front surface of the wiring body 3 can be suppressed, and a decrease in visibility of the wiring body 3 can be suppressed. Such a coating layer 9 is made of a resin material such as a UV curable resin, a thermosetting resin, or a thermoplastic resin such as an epoxy resin, an acrylic resin, a polyester resin, a urethane resin, a vinyl resin, a silicone resin, a phenolic resin, a polyimide resin or the like, or a ceramic green sheet. The "coating layer 9" in this embodiment corresponds to an example of the "coating layer" in the present invention. In a case where the coating layer 9 is disposed to directly cover the conductor portion 5, the wiring body 3 may include the coating layer 9 as the "coating layer" in the present invention.

Here, a structure is known in which a mountain shape portion is formed in a primer layer, and a conductive layer is formed corresponding to the mountain shape portion. In such a structure, since the mountain shape portion is formed in the primer layer, for example, a contact surface area between the primer layer and the conductive layer increases, and adhesiveness thereof is improved. However, in a case where a coating layer covering the conductive layer is formed on the structure of the related art, since a stress is easily concentrated on an interface between the conductive layer and the coating layer, peeling easily occurs between the conductive layer and the coating layer.

In addition, an electromagnetic shielding layer including: a conductive pattern in which conductive particles and a resin binder are contained and end corner portions of both side edges on a top surface does not protrude; and a metal layer in which end corner portions of both side edges protrude on the top surface of the conductive pattern and a central portion is recessed is known. In a case where such an electromagnetic shielding layer is covered with a adhesive agent layer or the like, there is a concern that peeling between the electromagnetic shielding layer and the metal layer occurs in preference to peeling between the electromagnetic shielding layer and the adhesive agent layer, and as a result thereof, there is a concern that the conductive pattern is destroyed.

In contrast, according to the wiring body 3 of this embodiment, as illustrated in Fig. 8, in a case where the coating layer 9 is formed on the conductor line 51, since the first and second protruding portions 561 and 562 enter (penetrate into) the coating layer 9, it is possible to suppress peeling between the wiring body 3 and the coating layer 9. In particular, since a stress is most easily concentrated on both ends of the conductor portion top surface 54 where the extending direction of planes are rapidly changed, both ends of the conductor portion top surface 54 easily become an origination of peeling between the wiring body 3 and the coating layer 9. Since the first and second protruding portions 561 and 562 are disposed corresponding to both ends of the conductor portion top surface 54 in the wiring body 3 of this embodiment, it is possible to more reliably suppress peeling between the wiring body 3 and the coating layer 9.

In this embodiment, the conductor portion 5 is formed of the single conductive material. For this reason, there is no interface in the conductor portion 5, and thus, interlayer peeling does not occur in the conductor portion 5. As a result thereof, it is possible to suppress the conductor portion 5 from being destroyed.

In this embodiment, the first and second protruding portions 561 and 562 are in a tapered shape in which the first and second protruding portions 561 and 562 are narrowed as being separated from the resin portion 4, and thus, the first and second protruding portions 561 and 562 easily enter the coating layer 9. Accordingly, it is possible to further suppress peeling between the coating layer 9 and the wiring body 3.

In this embodiment, the conductor portion 5 includes the conductive particles and the binder resin, and at least the tip ends 561c and 562c of the first and second protruding portions 561 and 562 are formed of the binder resin. In this case, since all of the tip ends 561c and 562c of the first and second protruding portions 561 and 562 and the coating layer 9 which are in contact with each other are made of the resin material, adhesiveness thereof is improved. Accordingly, it is possible to further suppress peeling between the wiring body 3 and the coating layer 9. In this embodiment, the tip ends 561c and 562c of the first and second protruding portions 561 and 562 are formed of the binder resin, that is, the tip ends 561c and 562c of the first and second protruding portions 561 and 562 are formed of the binder resin only, and thus, it is possible to give flexibility to the tip ends 561c and 562c on which a stress is easily concentrated. As a result thereof, it is possible to prevent the first and second protruding portions 561 and 562 from being broken, compared to a case where the tip end of the protruding portion contains the conductive particles.

In this embodiment, the first and second protruding portions 561 and 562 satisfy Expression (5) or Expression (6) described above, and thus, it is possible to suppress peeling between the coating layer 9 and the wiring body 3, and to suppress the occurrence of scattering of light in the first and second protruding portions 561 and 562. That is, the height and the width of the first and second protruding portions 561 and 562 satisfy Expression (5) and Expression (6) described above, and thus, it is possible to suppress an increase in the surface of the first and second protruding portions 561 and 562, and to suppress the occurrence of scattering of light. Further, at least the tip ends 561c and 562c of the first and second protruding portions 561 and 562 are formed of the binder resin (the conductive particles M having a high reflection rate of light do not enter the protruding portion), and thus, it is possible to further suppress the occurrence of scattering of light.

In the wiring body 3 of this embodiment, a relative relationship in the surface roughness between the conductor portion contact surface 53 and the conductor portion top surface 54 of the conductor line 51 (that is, a roughness parameter blocking a waviness component) is also considered, and the surface roughness Ra of the conductor portion contact surface 53 is relatively greater than the surface roughness Ra of the top surface. For this reason, it is possible to prevent light incident from the outside from being diffused and reflected while the resin portion 4 and the conductor line 51 rigidly adhere to each other. In particular, in a case where the width of the conductor line 51 is 1 $\mu$m to 5 $\mu$m, a relative relationship in the surface roughness between the conductor portion contact surface 53 and the conductor portion top surface 54 satisfies the relationship described above, and thus, an effect can be remarkable in which it is possible to prevent light incident from the outside from being diffused and reflected while the resin portion 4 and the conductor line 51 rigidly adhere to each other.

In this embodiment, the conductor portion top surface 54 includes the linear top surface flat portion 541 which is connected to the first and second protruding portions 561 and 562 in the width direction cross section of the conductor line 51, and thus, it is possible to prevent light incident from the outside from being diffused and reflected. In this embodiment, the first and second protruding portions 561 and 562 are disposed on both ends of the conductor portion top surface 54, but originally light is easily diffused and reflected at such an end portion, and thus, even though the first and second protruding portions 561 and 562 are disposed, the first and second protruding portions 561 and 562 rarely affect on the degree of diffusion and reflection of light on the conductor portion top surface 54. That is, as with this embodiment, the conductor portion top surface 54 includes the top surface flat portion 541 which is connected to the first and second protruding portions 561 and 562, and thus, it is possible to prevent light from being diffused and reflected while suppressing peeling between the wiring body 3 and the coating layer 9.

In this embodiment, the conductor portion top surface 54 includes the top surface flat portion 541, and thus, even in a case where the coating layer 9 is formed to cover the wiring body 3, air bubbles are hardly formed in the vicinity of the conductor portion top surface 54 of the conductor line 51. Accordingly, when the wiring body 3 is used as an electrode substrate of a touch panel or the like, it is possible to prevent light incident from the outside of the wiring body 3 from being diffused and reflected by air bubbles. For this reason, it is possible to further improve the visibility of the touch panel or the like on which the wiring body 3 is mounted. Air bubbles are hardly formed in the vicinity of the front surface of the conductor line 51, and thus, it is possible to suppress the conductor line 51 from being corroded due to moisture existing in the air bubbles. In particular, the width of the top surface flat portion 541 is 5 $\mu$m to 10 $\mu$m, and thus, air bubbles are hardly formed in the vicinity of the conductor portion top surface 54 of the conductor line 51.

In a case where the conductor portion top surface 54 includes the top surface flat portion 541 in the width direction cross section of the conductor line 51, an outer surface 91 of the coating layer 9 is easily formed to be flat. Accordingly, in a case where a film (not illustrated) is disposed on the outer surface 91 of the coating layer 9, it is possible to suppress the occurrence of distortion of the film while stably retaining the film by the outer surface 91 of the coating layer 9.

In this embodiment, since the conductor portion side surface 55 is inclined to be close to the center of the conductor line 51 as being separated from the resin portion 4 in the width direction cross section of the conductor line 51, even in a case where light incident on the inside of the wiring body 3 from the outside of the coating layer 9 side is reflected on the conductor portion side surface 55 of the conductor portion 5, reflection light is rarely leaked to the outside from the coating layer 9 side. Such a wiring body 3 is mounted on the touch panel or the like, and thus, it is possible to further improve the visibility of the touch panel or the like.

In this embodiment, the conductor portion side surface 55 includes the side surface flat portion 553 in the width direction cross section of the conductor line 51. In this case, in a case where the outer shape of the conductor line is a shape in which the conductor line is gradationally widened as being close to the resin portion in the width direction cross section of the conductor line, since the side surface of the conductor line is not in an arc shape in which the side surface is concave towards the inside (that is, a shape in which the skirt of the conductor line is widened), light incident from the outside of the wiring body 3 is prevented from being diffused and reflected. Such a wiring body 3 is mounted on the touch panel or the like, and thus, it is possible to further improve the visibility of the touch panel or the like.

In this embodiment, since the surface roughness Ra of the conductor portion contact surface 53 is relatively rougher than the surface roughness Ra of the surface other than the conductor portion contact surface 53 (a surface including the conductor portion top surface 54 and the conductor portion side surface 55), the diffused reflection rate of the wiring body 3 on the other surface side is relatively less than the diffused reflection rate of the wiring body 3 on the conductor portion contact surface 53 side. Here, in a case where a diffused reflection rate of an object is small, it is possible to prevent the object from appearing in white, and to suppress a decrease in a contrast in a region where the object can be viewed. Thus, it is possible to further improve the visibility of the touch panel or the like on which the wiring body 3 of this embodiment is mounted.

It is possible for the conductor portion 5 (the conductor line 51) and the resin portion 4 to rigidly adhere to each other, and thus, it is possible to prevent the conductor line 51 from being peeled from the resin portion 4 by curving or bending the wiring body 3, and to improve durability of the wiring body 3.

In this embodiment, a relationship between the height of the conductor line 51 and the width of the conductor line 51 is set to satisfy Expression (5) and Expression (6) described above, and thus, it is possible to reduce an electrical resistance value of the conductor line 51 per unit length while suppressing a decrease in the visibility of the wiring body 3.

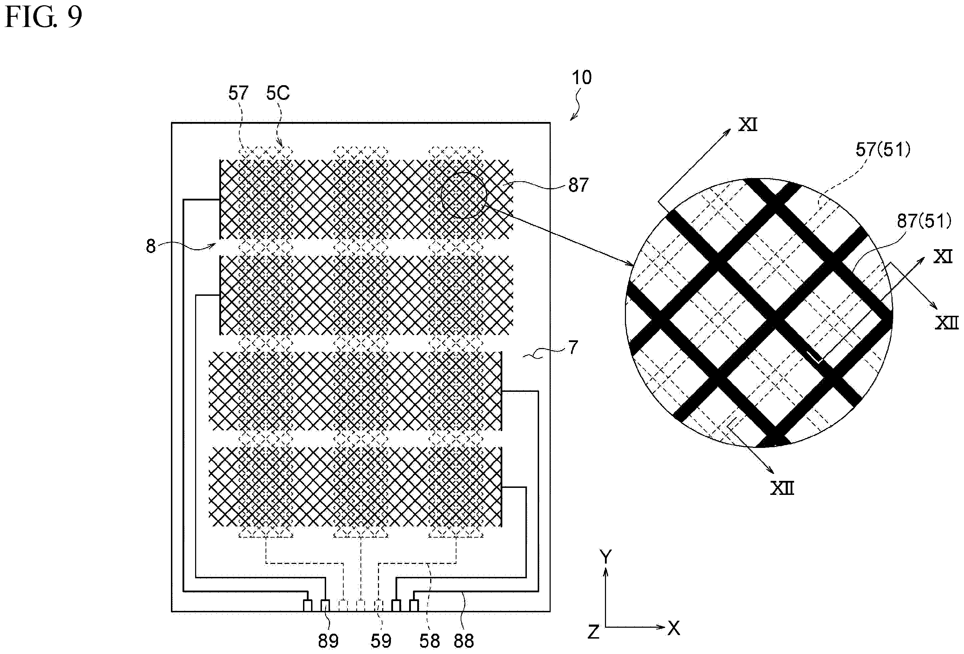

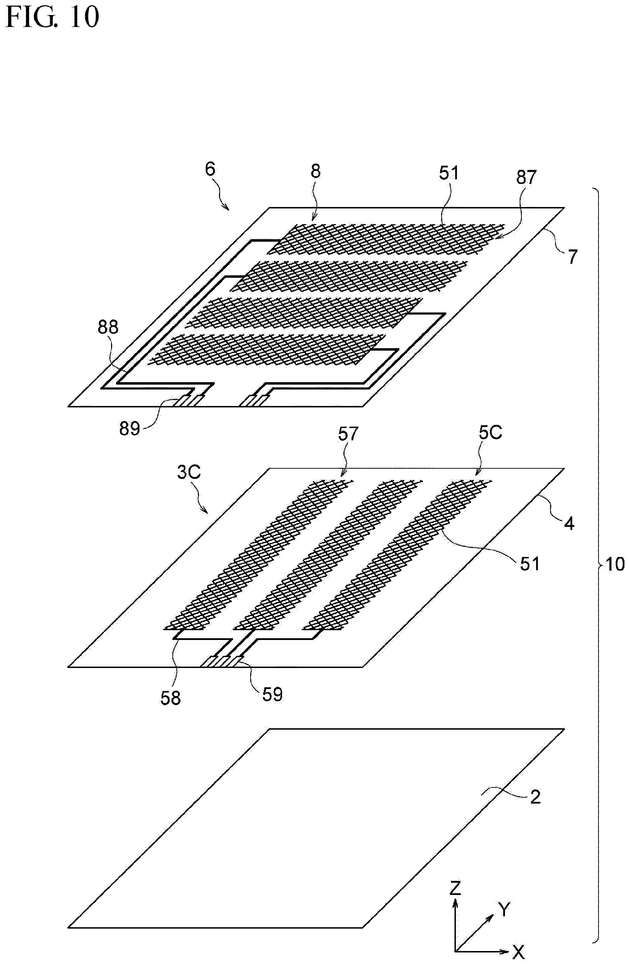

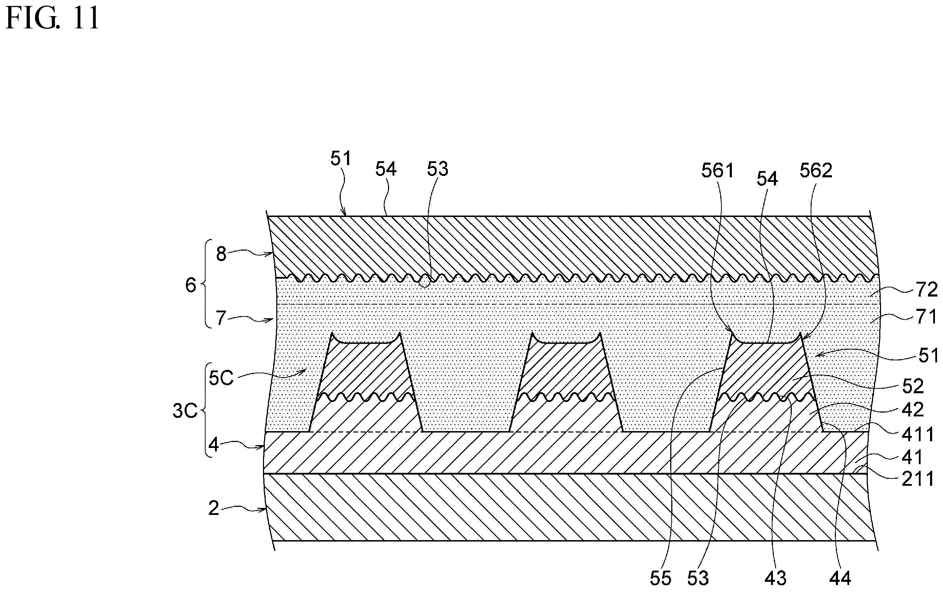

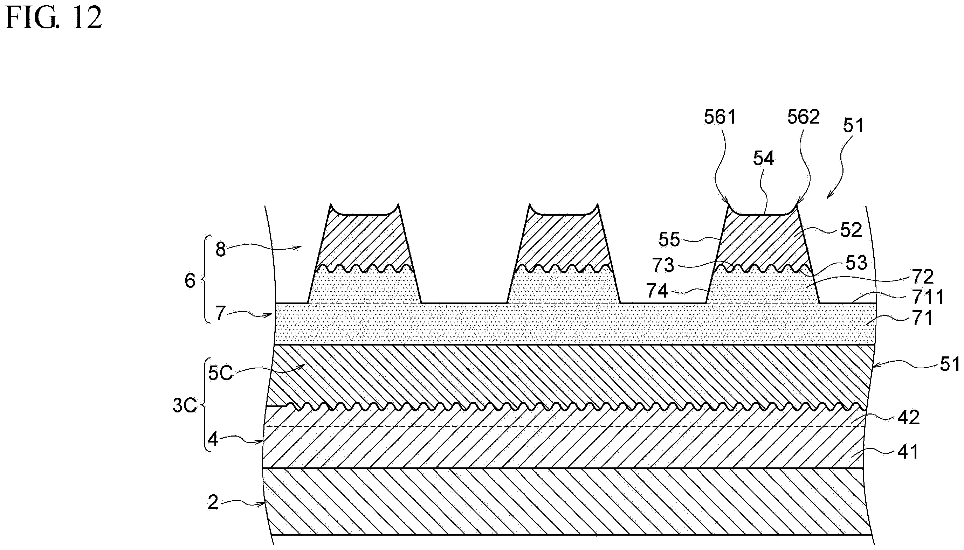

An example of a touch sensor 10 configured by laminating two wiring bodies described above will be described with reference to Fig. 9 to Fig. 12. Fig. 9 is a plan view illustrating the touch sensor in one embodiment of the present invention, Fig. 10 is an exploded perspective view illustrating the touch sensor in one embodiment of the present invention, Fig. 11 is a cross-sectional view along line XI-XI of Fig. 9, and Fig. 12 is a cross-sectional view along line XII-XII of Fig. 9.

As illustrated in Fig. 9, the touch sensor 10 of this embodiment is a projection electrostatic capacitance type touch panel sensor, and for example, is used as an input device having a function of detecting a touch position by being combined with a display device (not illustrated) or the like. The display device is not particularly limited, and a liquid crystal display, an organic EL display, electronic paper or the like can be used. The touch sensor 10 includes a detection electrode and a driving electrode disposed to face each other (a first electrode 57 and a second electrode 87 described below), and a predetermined voltage is periodically applied between two electrodes from an external circuit (not illustrated).

In such a touch sensor 10, for example, in a case where a finger of an operator (an external conductor) is close to the touch sensor 10, a capacitor (electrostatic capacitance) is formed between the external conductor and the touch sensor 10, and an electrical state between two electrodes is changed. The touch sensor 10 is capable of detecting an operating position of the operator on the basis of an electrical change between two electrodes.

As illustrated in Fig. 10 to Fig. 12, the touch sensor 10 is configured of a wiring board 1C including the substrate 2, a first wiring body 3C and a second wiring body 6. The first wiring body 3C includes the resin portion 4 (hereinafter, referred to as a first resin portion 4 in the description of the touch sensor 10) and a first conductor portion 5C. The first conductor portion 5C includes a plurality of first electrodes 57 for detection, a plurality of first lead-out wirings 58 and a plurality of first terminals 59. The number of first electrodes 57 of the first wiring body 3C is not particularly limited and can be arbitrarily set. The number of first lead-out wirings 58 and the number of first terminals 59 of the first wiring body 3C is set according to the number of first electrodes 57.

Each of the first electrodes 57 extends in a Y direction of the drawing, and the plurality of first electrodes 57 are parallel in an X direction of the drawing. One end of each of the first lead-out wirings 58 is connected to one longitudinal direction end of each of the first electrodes 57. The first terminal 59 electrically connected to the external circuit is connected to the other end of each of the first lead-out wirings 58.

The first electrode 57 is in a mesh shape (a reticular shape) configured of a plurality of linear conductor lines 51. As with the first electrode 57, the first lead-out wiring 58 and the first terminal 59 are also configured of the linear conductor line 51. The first lead-out wiring 58 and the first terminal 59 may be configured of the single conductor line 51, or may be in a mesh shape (a reticular shape) configured of the plurality of conductor lines 51.

The second wiring body 6 includes a second resin portion 7 and a second conductor portion 8. The second resin portion 7, for example, is made of an insulating material such as a UV curable resin, a thermosetting resin or a thermoplastic resin such as an epoxy resin, an acrylic resin, a polyester resin, a urethane resin, a vinyl resin, a silicone resin, a phenolic resin or a polyimide resin, or a ceramic green sheet. In this embodiment, the second resin portion 7 has a function as an insulating portion which ensures insulating between the first conductor portion 5C of the first wiring body 3C and the second conductor portion 8 of the second wiring body 6.

As illustrated in Fig. 12, the second resin portion 7 includes a layer-like flat portion 71 directly disposed on the first wiring body 3C and a convex portion 72 disposed on the flat portion 71 and integrally formed with the flat portion 71. The flat portion 71 is disposed to cover the first conductor portion 5C and includes a portion having a substantially constant thickness between the first conductor portion 5C and the convex portion 72. A main surface 711 of the flat portion 71 is approximately an even surface and extends substantially in parallel with the main surface 211 of the substrate 2 (the main surface 411 of the first resin portion 4).

The convex portion 72 is disposed corresponding to the second conductor portion 8 (specifically, the conductor line 51) and supports the second conductor portion 8. The convex portion 72 protrudes towards the second conductor portion 8 side from the main surface 711 of the flat portion 71 in the width direction cross section of the conductor line 51. In the second wiring body 6, the convex portion 72 is formed between the flat portion 71 and the second conductor portion 8, and thus, the thickness of the second resin portion 7 increases at a portion supporting the second conductor portion 8, and rigidity of the second resin portion 7 is improved. Accordingly, when the second wiring body 6 is curved, the second conductor portion 8 is hardly peeled from the second resin portion 7. The height of the convex portion 72 is not particularly limited. For example, the height of the flat portion 71 may be equal to the height of the convex portion 72. Alternatively, the height of the flat portion 71 may be higher than the height of the convex portion 72, or on the contrary, the height of the flat portion 71 may be lower than the height of the convex portion 72.

The convex portion 72 includes a resin portion contact surface 73 and a resin portion side surface 74 in the width direction cross section of the conductor line 51. The resin portion contact surface 73 is a surface in contact with the conductor portion 8. In this embodiment, the conductor portion contact surface 53 of the second conductor portion 8 (specifically, the conductor line 51) is in an unevenness shape, and thus, the resin portion contact surface 73 is in an unevenness shape which is complementary with respect to the unevenness shape of the conductor portion contact surface 53. As illustrated in Fig. 11, the resin portion contact surface 73 and the conductor portion contact surface 53 are also in a complementary unevenness shape in the extending direction cross section of the conductor line 51. In Fig. 11 and Fig. 12, in order to describe the second wiring body 6 of this embodiment to be easily understood, the unevenness shape of the resin portion contact surface 73 and the conductor portion contact surface 53 is exaggerated.

As illustrated in Fig. 12, the resin portion side surface 74 is connected to the resin portion contact surface 73 at one end portion, is 1 connected to the main surface 711 at the other end portion, and is a surface which linearly extends between both ends. In one convex portion 72, the resin portion side surfaces 74 and 74 are inclined to close to each other as being separated from the flat portion 71. As a result thereof, the convex portion 72 is in a tapered shape in which the convex portion 72 is narrowed as being separated from the flat portion 71 in the width direction cross section of the conductor line 51.

The second conductor portion 8 includes a plurality of second electrodes 87, a plurality of second lead-out wirings 88 and a plurality of second terminals 89. The number of second electrodes 87 of the second wiring body 6 is not particularly limited and can be arbitrarily set. The number of second lead-out wirings 88 and the number of second terminals 89 of the second wiring body 6 is set according to the number of second electrodes 87.

Each of the second electrodes 87 extends in a direction orthogonal to each of the second electrodes 87 of the first wiring body 3C (the X direction in the drawing), and the plurality of second electrodes 87 are parallel in the Y direction of the drawing. One end of each of the second lead-out wirings 88 is connected to one longitudinal direction end of each of the second electrodes 87. The second terminal 89 is disposed on the other end of each of the second lead-out wirings 88. The second terminal 89 is electrically connected to the external circuit.

The second electrode 87 is in a mesh shape (a reticular shape) configured of the plurality of linear conductor lines 51. As with the second electrode 87, the second lead-out wiring 88 and the second terminal 89 are configured of the linear conductor line 51. The second lead-out wiring 88 and the second terminal 89 may be configured of the single conductor line 51, or may be in a mesh shape (a reticular shape) configured of the plurality of conductor lines 51.

In the touch sensor 10 of this embodiment, the first conductor portion 5C of the first wiring body 3C is configured of the conductor line 51. The conductor line 51 includes the first and second protruding portions 561 and 562. For this reason, in this embodiment, the first and second protruding portions 561 and 562 enter (penetrate into) the second resin portion 7 of the second wiring body 6, and thus, it is possible to suppress peeling between the first wiring body 3C and the second wiring body 6.

In the touch sensor 10 of this embodiment, the second conductor portion 8 of the second wiring body 6 is configured of the conductor line 51. For this reason, in a case where a coating layer (not illustrated) is formed on the second conductor portion 8, the first and second protruding portions 561 and 562 of the conductor line 51 enter (penetrate into) the coating layer, and thus, it is possible to suppress peeling between the second wiring body 6 and the coating layer.

In a case where the "first wiring body 3C" in this embodiment corresponds to an example of the "wiring body" in the present invention, the "second resin portion 7" in this embodiment corresponds to an example of the "coating layer" in the present invention. In a case where the "second wiring body 6" in this embodiment corresponds to an example of the "wiring body" in the present invention, the coating layer disposed on the second wiring body 6 to cover the second conductor portion 8 corresponds to an example of the "coating layer" in the present invention. In a case where the second resin portion 7 is disposed to directly cover the first conductor portion 5C, the first wiring body 3C may include the second resin portion 7 as the "coating layer" in the present invention. In a case where the coating layer is disposed to directly cover the second conductor portion 8, the second wiring body 6 may include the coating layer as the "coating layer" in the present invention.

Embodiments heretofore explained are described to facilitate understanding of the present invention and are not described to limit the present invention. It is therefore intended that the elements disclosed in the above embodiments include all design changes and equivalents to fall within the technical scope of the present invention.

For example, the touch sensor of the embodiment described above is the projection electrostatic capacitance type touch sensor using two wiring boards 1 (two wiring bodies 3), but is not particularly limited thereto, and it is also possible to apply the present invention to a surface (capacitive coupling) electrostatic capacitance type touch sensor using one wiring board (one wiring body).

A metal material and a carbon-based material may be used in the conductor portion 5 by being mixed. In this case, for example, the carbon-based material may be disposed on the top surface side of the conductor pattern, and the metal material may be disposed on the contact surface side. On the contrary, the metal material may be disposed on the top surface side of the conductor pattern, and the carbon-based material may be disposed on the contact surface side.

The conductor layer may be formed to cover at least a part of the top surface of the conductor portion 5. In this case, the material configuring the conductor layer which covers the conductor portion 5 may be different from the material configuring the conductor portion 5.

Even though it is not particularly illustrated, the substrate 2 of the embodiment described above may be omitted from the wiring body 3. In this case, for example, a wiring body may be configured such that a peeling sheet is disposed on a lower surface of the resin portion 4, the peeling sheet is peeled off at the time of mounting the wiring body, and the wiring body is mounted on a mounting target (a film, surface glass, a polarizing plate, display glass or the like) by adhering thereto. A wiring body may be configured such that a resin portion is further disposed to cover the wiring body 3 from the resin portion 4 (the resin portion) side, and the wiring body is mounted on the mounting target described above by adhering thereto through the resin portion. A wiring body may be configured such that a resin portion is disposed to cover the wiring body 3 from the conductor portion 5 side, the wiring body is mounted on the mounting target described above by adhering thereto through the resin portion. In these case, the mounting target on which the wiring body is mounted corresponds to an example of the support body in the present invention.

Further, in the embodiment described above, the wiring body has been described as being used in the touch sensor or the like, but is not particularly limited thereto. For example, the wiring body may be used as a heater by energizing the wiring body to generate heat according to resistance heating or the like. In this case, it is preferable that a carbon-based material having a high comparatively electrical resistance value is used as the conductive particles of the conductor portion. A part of the conductor portion of the wiring body is grounded, and thus, the wiring body may be used as an electromagnetic shielding shield. The wiring body may be used as an antenna. In these case, the mounting target on which the wiring body is mounted corresponds to an example of the support body in the present invention.

EXPLANATIONS OF LETTERS OR NUMERALS

| 10 | touch sensor |
|---|---|
| 1 | wiring board |
| 2 | substrate |
| 211 | main surface |
| 3, 3C | wiring body (first wiring body) |
| 4 | resin portion |
| 41 | flat portion |
| 411 | main surface |
| 42 | convex portion |
| 43 | resin portion contact surface |
| 44 | resin portion side surface |
| 5, 5C | conductor portion |
| 51, 51B | conductor line |
| 52 | main body portion |
| 53 | conductor portion contact surface |
| 54 | conductor portion top surface |
| 541 | top surface flat portion |
| $L_1$ | first virtual straight line |
| 55 | conductor portion side surface |
| 551, 552 | end portion |
| 553 | side surface flat portion |
| $L_2$ | second virtual straight line |
| 561, 562 | first and second protruding portions |
| 561a, 562a | outer side surface |
| 561b, 562b | inner side surface |
| 561c, 562c | tip end |
| M | conductive particles |
| B | binder resin |
| 57 | first electrode |
| 58 | first lead-out wiring |
| 59 | first terminal |
| 6 | second wiring body |

| 7 | second resin portion |
|---|---|
| 71 | flat portion |
| 711 | main surface |
| 72 | convex portion |
| 73 | resin portion contact surface |
| 74 | resin portion side surface |
| 8 | second conductor portion |
| 87 | second electrode |
| 88 | second lead-out wiring |
| 89 | second terminal |
| 9 | coating layer |
| 91 | outer surface |
| 100 | intaglio |
| 101 | concave portion |
| 102 | inner wall |
| 103 | bottom surface |
| 104, 105 | recessed portion |
| 110 | matrix |
| 111 | convex portion |
| 112, 113 | protruding portion |
| 114 | metal layer |
| 120 | conductive material |
| 130 | resin material |

**Claims**

1. A wiring body comprising:

   a resin portion; and
   a conductor portion which is disposed on the resin portion and is formed of a single conductive material, wherein
   the conductor portion includes
   a main body portion which includes

      a contact surface in contact with the resin portion, and
      a top surface on a side opposite to the contact surface; and

      a protruding portion which is disposed on at least one end portion of the top surface and protrudes towards a side separated from the resin portion in the cross-sectional view.

2. The wiring body according to claim 1, wherein the protruding portion is disposed on both ends of the top surface in the cross-sectional view.

3. The wiring body according to claim 1 or 2, wherein the protruding portion is in a tapered shape in which the protruding portion is narrowed as being directed towards a side separated from the resin portion.

4. The wiring body according to any one of claims 1 to 3, wherein
   the conductor portion includes conductive particles and a binder resin, and at least a tip end of the protruding portion is formed of the binder resin.

5. The wiring body according to any one of claims 1 to 4, wherein a following Expression (1) is satisfied:

$$0.1 \ \mu m \leq H_1 \leq 1.0 \ \mu m \ \ldots(1)$$

where $H_1$ is a height of the protruding portion in the Expression (1).

6. The wiring body according to any one of claims 1 to 5, wherein a following Expression (2) is satisfied:

$$0.1 \ \mu m \leq W_1 \leq 1.0 \ \mu m \ \ldots(2)$$

where $W_1$ is a width of the protruding portion in the Expression (2),.

7. The wiring body according to any one of claims 1 to 6, wherein
surface roughness of the contact surface is relatively greater than surface roughness of the top surface.

8. The wiring body according to any one of claims 1 to 7, wherein
the top surface includes a flat portion which is linear and is connected to the protruding portion in the cross-sectional view.

9. The wiring body according to claim 8, wherein
a width of the flat portion is greater than or equal to half of a width of the top surface.

10. The wiring body according to any one of claims 1 to 9, wherein
the main body portion includes a side surface interposed between the contact surface and the top surface in the cross-sectional view, and
the side surface is inclined to be close to the center of the conductor portion as being separated from the resin portion in the cross-sectional view.

11. The wiring body according to any one of claims 1 to 10 further comprising:
a coating layer which is disposed to directly cover the conductor portion.

12. A wiring board comprising:

the wiring body according to any one of claims 1 to 11; and
a support body which supports the wiring body.

13. A touch sensor comprising:

the wiring board according to claim 12.

FIG. 1

FIG. 2

EP 3 429 319 A1

FIG. 3

EP 3 429 319 A1

FIG. 4

EP 3 429 319 A1

FIG. 5(A)

FIG. 5(B)

FIG. 5(C)

FIG. 5(D)

FIG. 5(E)

FIG. 6(A)

FIG. 6(C)

FIG. 6(B)

EP 3 429 319 A1

FIG. 7(A)

120

100

FIG. 7(B)

120

100

FIG. 7(C)

120   130

100

FIG. 7(D)

130

120   100

FIG. 7(E)

3
4
5

100

EP 3 429 319 A1

FIG. 8

# FIG. 9

EP 3 429 319 A1

# FIG. 10

EP 3 429 319 A1

FIG. 11

FIG. 12

EP 3 429 319 A1

**EP 3 429 319 A1**

## INTERNATIONAL SEARCH REPORT

| International application No. |
|---|
| PCT/JP2017/009122 |

| A. CLASSIFICATION OF SUBJECT MATTER |
|---|
| *H05K1/02*(2006.01)i, *G06F3/041*(2006.01)i, *G06F3/044*(2006.01)i, *H05K3/20* (2006.01)i |

According to International Patent Classification (IPC) or to both national classification and IPC

| B. FIELDS SEARCHED |
|---|
| Minimum documentation searched (classification system followed by classification symbols) |
| H05K1/02, G06F3/041, G06F3/044, H05K3/20 |

Documentation searched other than minimum documentation to the extent that such documents are included in the fields searched

| Jitsuyo Shinan Koho | 1922–1996 | Jitsuyo Shinan Toroku Koho | 1996–2017 |
|---|---|---|---|
| Kokai Jitsuyo Shinan Koho | 1971–2017 | Toroku Jitsuyo Shinan Koho | 1994–2017 |

Electronic data base consulted during the international search (name of data base and, where practicable, search terms used)

| C. DOCUMENTS CONSIDERED TO BE RELEVANT |
|---|

| Category* | Citation of document, with indication, where appropriate, of the relevant passages | Relevant to claim No. |
|---|---|---|
| Y | JP 2014-191717 A (Dainippon Printing Co., Ltd.), 06 October 2014 (06.10.2014), paragraphs [0014] to [0085]; fig. 1 to 5 (Family: none) | 1-13 |
| Y | JP 2012-169353 A (Dainippon Printing Co., Ltd.), 06 September 2012 (06.09.2012), paragraph [0034]; fig. 1 (Family: none) | 1-13 |

| ☒ Further documents are listed in the continuation of Box C. | ☐ See patent family annex. |
|---|---|

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 18 May 2017 (18.05.17) | 30 May 2017 (30.05.17) |

| Name and mailing address of the ISA/ | Authorized officer |
|---|---|
| Japan Patent Office 3-4-3,Kasumigaseki,Chiyoda-ku, Tokyo 100-8915,Japan | |
| | Telephone No. |

Form PCT/ISA/210 (second sheet) (January 2015)

**INTERNATIONAL SEARCH REPORT**

International application No.

PCT/JP2017/009122

C (Continuation). DOCUMENTS CONSIDERED TO BE RELEVANT

| Category* | Citation of document, with indication, where appropriate, of the relevant passages | Relevant to claim No. |
|---|---|---|
| Y | WO 2008/149969 A1 (Dainippon Printing Co., Ltd.), 11 December 2008 (11.12.2008), paragraphs [0001], [0098]; fig. 4, 13 & US 2010/0230154 A1 paragraphs [0001], [0121]; fig. 4, 13 & JP 2010-123979 A & JP 2010-123980 A & JP 2013-16852 A | 7 |
| A | JP 2006-302930 A (Matsushita Electric Industrial Co., Ltd.), 02 November 2006 (02.11.2006), entire text & US 2008/0135283 A1 entire text & WO 2006/112384 A1 & CN 101156238 A | 1-13 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016044106 A
- WO 2008149969 A
- JP 2012169353 A
- JP 2011071542 A